# EUROPÄISCHE PATENTSCHRIFT

(11) **EP 1 041 709 B1**
(45) Veröffentlichungstag und Bekanntmachung des Hinweises auf die Patenterteilung: **16.09.2009**
(21) Anmeldenummer: 00103582.3
(22) Anmeldetag: 19.02.2000
(51) Int. Cl.: H03B 5/36, H03K 3/354

(54) **Oszillatorschaltung**
Oscillator circuit
Circuit oscillateur

(30) Priorität: 20.03.1999 DE 19912704
(43) Veröffentlichungstag der Anmeldung: 04.10.2000
(73) Patentinhaber: Micronas GmbH, 79108 Freiburg i. Br. (DE)
(72) Erfinder: Theus, Ulrich, Dr., 79194 Gundelfingen (DE)
(74) Vertreter: Patentanwälte Westphal, Mussgnug & Partner

(56) Entgegenhaltungen:
- GB-A- 1 602 371
- US-A- 3 855 549
- PATENT ABSTRACTS OF JAPAN vol. 004, no. 028 (E-001), 8. März 1980 (1980-03-08) & JP 55 003263 A (SEIKO INSTR & ELECTRONICS LTD), 11. Januar 1980 (1980-01-11)

## Beschreibung

Die vorliegende Erfindung betrifft eine Oszillatorschaltung gemäß den Merkmalen des Oberbegriffs des Anspruchs 1.

Eine solche Oszillatorschaltung ist z. B. aus GB-A-1602371 bekannt. Eine ähnliche Oszillatorschaltung ist unter anderem in IEEE Journal of Solid-State Circuits, Vol. 32, No. 7, July 1997, auf den Seiten 999 bis 1005 beschrieben. Die offenbarte Oszillatorschaltung (vgl. dort Fig. 4), ist für Uhrenquarze ausgelegt und zeichnet sich durch eine minimale Stromaufnahme aus. Die Schwingungsamplituden des Oszillators liegen lediglich in der Größe von etwa 0,2 ± 0,05 Volt. Ein robuster Betrieb der Oszillatorschaltung mit mindestens 2 Volt Schwingungsamplituden ist mit einer solchen Oszillatorschaltung ausgeschlossen.

Aufgabe der vorliegenden Erfindung ist es, eine verbesserte Oszillatorschaltung zur Verfügung zu stellen, die sowohl bei der Verwendung von Resonatoren mit hoher Dämpfung als auch bei der Verwendung von Resonatoren mit niedriger Dämpfung zuverlässig funktioniert und die insbesondere große Schwingungsamplituden bei geringer Stromaufnahme ermöglicht.

Diese Aufgabe wir durch eine Oszillatorschaltung mit den Merkmalen des Anspruchs 1 gelöst.

Die Oszillatorschaltung nach der Erfindung weist demnach folgende Merkmale auf:
- einen Resonator (RES);
- eine Entdämpfungseinrichtung (ENT) zur Amplitudenregelung der Schwingungsamplitude des Resonator (RES) mit einer ersten Anschlussklemme (K1) und einer zweiten Anschlussklemme (K2) zum Anschließen des Resonators (RES) ;
- die Entdämpfungsschaltung (ENT) weist eine einstellbare Verstärkung und/oder Steilheit auf;
- die Werte der Verstärkung und/oder Steilheit sind in Abhängigkeit der Schwingungsamplitude regelbar; und
- die geregelten Werte der Verstärkung und/oder Steilheit sind während der ganzen Schwingungsamplitude im wesentlichen unabhängig von der Momentanspannung und/oder dem Momentanstrom an den Anschlußklemmen (K1, K2) der Entdämpfereinrichtung (ENT) und bleiben damit konstant.

In einer konkreten Ausführungsform ist zwischen die Klemme für Versorgungsspannung und Bezugspotential die Reihenschaltung von vier Transistoren vorgesehen. Ein erster und zweiter Transistor liegen in Reihe mit ihren Laststrecken zwischen einem Knoten für Versorgungspotential und einer ersten Anschlussklemme, an die der Resonator angeschlossen ist. Ein dritter und vierter Transistor liegt in Reihe zwischen dieser Anschlussklemme und einem Knoten für Bezugspotential. Die Steueranschlüsse des erwähnten ersten und vierten Transistors sind mit einer zweiten Anschlussklemme des Resonators in Verbindung, während mindestens eine Spitzenwerterfassungseinheit vorgesehen ist, deren Eingangsklemme an die erste Anschlussklemme und deren Ausgangsklemme an den Steueranschluss des dritten und/oder zweiten Transistors der Reihenschaltung von Transistoren angschlossen ist.

An der Ausgangsklemme der Spitzenwerterfassungseinheit steht ein Signal zur Verfügung, welches abhängig von der Amplitude des an der ersten Anschlußklemme anliegenden Schwingungssignals ist.

Mit zunehmender Schwingungsamplitude wird der zweite und/oder dritte Transistor über das an der Ausgangsklemme der Spitzenwerterfassungseinheit anliegende Signal abgeregelt. Der an die Ausgangsklemme fließende Strom hängt bei der erfindungsgemäßen Oszillatorschaltung neben dem Momentanwert des Schwingungssignals damit von der Amplitude der Schwingung ab. Die Transistoren sind dabei so dimensioniert, daß anfangs, wenn die Amplitude der Schwingung klein ist und der zweite und dritte Transistor noch nicht abgeregelt werden, die Entdämpfungseinrichtung eine große Steilheit aufweist, um auch (schlechte) Resonatoren mit großer Dämpfung zum Schwingen anregen zu können. Die Steilheit des ersten und vierten Transistors kann dabei ein Vielfaches der Steilheiten vergleichbarer Transistoren bei bekannten derartigen Schaltungen betragen. Mit zunehmender Amplitude der Schwingung werden der zweite und/oder dritte Transistor abgeregelt, um die Stromaufnahme bei großen Amplituden, im eingeschwungenen Zustand gering zu halten.

Die erfindungsgemäße Schaltung funktioniert damit zuverlässig auch mit Resonatoren, deren Dämpfungen in weiten Bereichen schwanken können, ohne daß die Stromaufname bei sehr guten Resonatoren mit geringer Dämpfung erhöht wäre.

Vorteilhafte Ausgestaltungen der Erfindung sind Gegenstand der Unteransprüche.

Eine Ausführungsform der Erfindung sieht eine erste und zweite Spitzenwerterfassungseinheit vor, wobei eine Eingangsklemme der ersten Spitzenwerterfassungseiheit an die erste Anschlußklemme und eine Ausgansgsklemme zur Ansteuerung des zweiten Transistors an dessen Steueranschluß angeschlossen ist. Eine Eingangsklemme der zweiten Spitzenwerterfassungseinheit ist an die zweite Anschlußklemme angeschlossen und eine Ausgangsklemme ist zur Ansteuerung des dritten Transistors an dessen Steueranschluß angeschlossen.

Die Spitzenwerterfassungseinheiten weisen gemäß einer Ausführungsform der Erfindung jeweils eine Kapazität, eine Diode und einen Widerstand auf. Die Kapazität ist bei der ersten Spitzenwerterfassungseinheit mit einer Klemme an den Knoten für Versorgungspotential und mit der anderen Klemme über die Diode an die erste Anschlußklemme angeschlossen. Der Widerstand ist zwischen den der Diode und der Kapazität gemeinsamen Knoten und den Knoten für Bezugspotential geschaltet. Der Steueranschluß des zweiten Transistors ist an den der Kapazität und der Diode gemeinsamen Knoten angeschlossen, wodurch das Potential an diesem Knoten zur Ansteuerung dieses Transistors dient. Abhängig von der verwendeten Transistortechnologie steigt bzw. fällt das Potential an diesem Knoten mit zunehmender Amplitude der an der ersten Anschlußklemme anliegenden Spannung, um den zweiten Transistor abzuregeln.

Bei der zweiten Spitzenwerterfassungseinheit ist die Kapazität mit einer Klemme an den Knoten für Bezugspotential und mit der anderen Klemme über eine Diode an die erste Anschlußklemme angeschlossen. Der Steueranschluß des dritten Transistors ist an den der Kapazität und der Diode gemeinsamen Knoten angeschlossen, wodurch das Potential an diesem Knoten zur Ansteuerung dieses Transistors dient. Ein Widerstand ist weiterhin zwischen diesen Knoten und den Knoten für Versorgungspotential zur Aufladung der Kapazität geschaltet. Abhängig von der verwendeten Transistortechnologie steigt bzw. fällt das Potential an dem der Diode und Kapazität gemeinsamen Knoten mit zunehmender Amplitude der an der ersten Anschlußklemme anliegenden Spannung, um den dritten Transistor abzuregeln.

Weitere Ausführungsformen der Erfindung sehen vor, eine dritte Diode zwischen die zweite Anschlußklemme und die Kapazität der ersten Spitzenwerterfassungseinheit zu schalten und eine vierte Diode zwischen die zweite Anschlußklemme und die Kapazität der zweiten Spitzenwerterfassungseinheit zu schalten. An der ersten und zweiten Anschlußklemme liegen bei üblicher Verschaltung des Oszillators Signale an, die sich lediglich in einer 180°-Phasenverschiebung unterscheiden. Die Erfassung der Amplituden an der ersten und zweiten Anschlußklemme durch die Spitzenwerterfassungseinheiten ermöglicht eine schnellere Regelung der zweiten und dritten Transistoren.

Eine Ausführungsformen der Erfindung sieht vor, anstelle der Widerstände der Spitzenwerterfassungseinheiten Stromquellen, insbesondere Stromspiegel vorzusehen, die insbesondere in MOS-Technologie platzsparend realisierbar sind. Des weiteren ist vorgesehen, den ersten und zweiten Transistor als p-Kanal-FET und den dritten und vierten Transistor als n-Kanal-FET auszubilden. Vorteilhafterweise sind die Dioden der Spitzenwerterfassungseinheiten als Transistoren, insbesondere als FET ausgebildet, die durch Verbinden der Gate- und Drain-Anschlüsse als Dioden verschaltet sind. Weiterhin ist vorgesehen, das Gate-Oxid der MOS-Technologie als Kapazitäten in den Spitzenwerterfassungseinheiten zu verwenden. Die zuletzt genannten Ausführungsformen erlauben eine Realisierung der erfindungsgemäßen Schaltung in platzsparender Weise in MOS-Technologie.

Die Erfindung wird nachfolgend in Ausführungsbeispielen anhand von Figuren näher erläutert. Es zeigen:
- Figur 1:: erfindungsgemäße Oszillatorschaltung gemäß einer er- sten Ausführungsform der Erfindung;
- Figur 2:: erfindungsgemäße Oszillatorschaltung gemäß einer zwei- ten Ausführungsform der Erfindung;
- Figur 3:: erfindungsgemäße Oszillatorschaltung gemäß einer drit- ten Ausführungsform der Erfindung.

In den Figuren bezeichnen, sofern nicht anders angegeben gleiche Bezugszeichen gleiche Bauteile mit gleicher Bedeutung.

Die Erfindung ist nachfolgend ohne Beschränkung der Allgemeinheit unter Verwendung von p-Kanal-FET für den ersten und zweiten Transistor und unter Verwendung von n-Kanal-FET für den dritten und vierten Transistor erläutert. Selbstverständlich kann auch eine Realisierung des ersten und zweiten Transistors als n-Kanal-FET und des dritten und vierten Transistors als p-Kanal-FET erfolgen, wobei dann polungsabhängige Bauteile, wie Dioden, und die Versorgungsspannungen umzupolen sind. Auch einer Realisierung in einer anderen Transistortechnologie steht nichts im Wege.

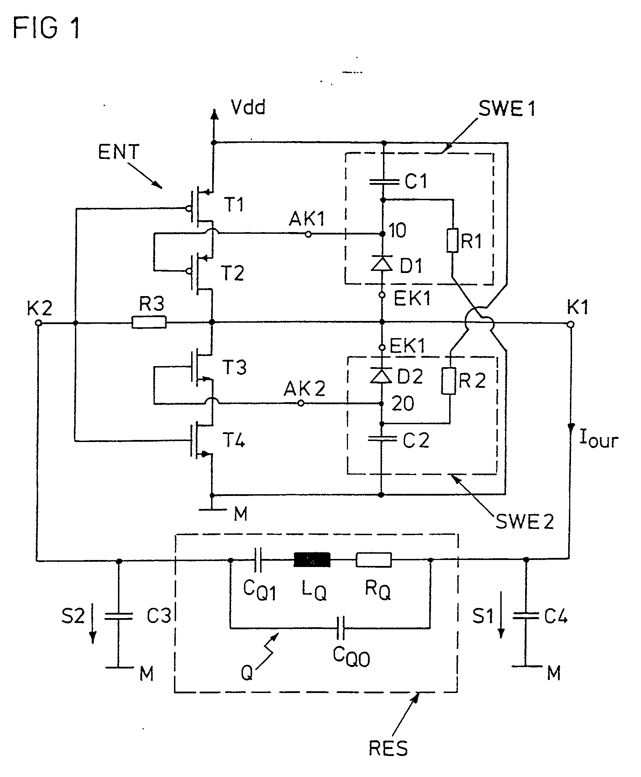

Fig. 1 zeigt eine erste Ausführungsform einer erfindungsgemäßen Oszillatorschaltung mit einem Resonator RES und einer Entdämpferschaltung ENT. Die Entdämpferschaltung ENT weist eine erste und zweite Anschlußklemme K1, K2 auf, an denen ein Resonator RES angeschlossen ist. Als Resonator RES dient für das vorliegende Ausführungsbeispiel ein Quarz Q, dessen elektrisches Ersatzschaltbild gegeben ist durch die Reihenschaltung einer Kapazität C_{Q1}, einer Induktivität L_{Q}, und eines Widerstands R_{Q}, wobei der Reihenschaltung eine Kapazität C_{Q0} parallel geschaltest ist. Der Quarz Q ist zwischen die erste und zweite Anschlußklemme K1, K2 der Ansteuerschaltung geschaltet, wobei jeweils eine Kapazität C3, C4 zwischen die Anschlußklemmen K1, K2 und ein Bezugspotential M geschaltet ist.

Die Entdämpferschaltung ENT weist eine Reihenschaltung eines ersten und zweiten Transistors T1, T2 zwischen einem Knoten für Versorgungspotential Vdd und der ersten Anschlußklemme K1 und eine Reihenschaltung eines dritten und vierten Transistors T3, T4 zwischen der ersten Anschlußklemme K1 und dem Knoten für Bezugspotential M auf. Der erste und zweite Transistor T1, T2 sind in dem dargestellten Ausführungsbeispiel als p-Kanal-MOSFET, der dritte und vierte Transistor T3, T4 als n-Kanal-MOSFET ausgebildet. Steueranschlüsse, in dem dargestellten Ausführungsbeispiel die Gate-Anschlüsse, des ersten und vierten Transistors T1, T4 sind an die zweite Anschlußklemme K2 angeschlossen.

Die Schaltung verfügt des weiteren über eine erste Spitzenwerterfassungseinheit SWE1 mit einer Eingangsklemme EK1, die an die erste Anschlußklemme K1 angeschlossen ist, und mit einer Ausgangsklemme AK1, die an den Gate-Anschluß des zweiten Transistors T2 angeschlossen ist. Die erste Spitzenwerterfassungseinheit SWE1 weist eine mit einer ersten Klemme an den Knoten für Versorgungspotential Vdd angeschlossene erste Kapazität C1 auf, die über eine erste Diode D1 an die erste Anschlußklemme K1 angeschlossen ist, wobei die Anode der ersten Diode D1 an die erste Anschlussklemme EK1 und die Kathode an die erste Kapazität C1 angeschlossen ist. Ein der Kapazität C1 und der Diode D1 gemeinsamer Knoten 10 ist an die Ausgangsklemme AK1 und damit an das Gate des zweiten Transistors T2 angeschlossen. Zwischen diesen Knoten 10 und den Knoten für Bezugspotential M ist ein Widerstand R1 geschaltet.

Weiterhin verfügt die Schaltung über eine zweite Spitzenwerterfassungseinheit SWE2 mit einer Eingangsklemme EK2, die an die erste Anschlußklemme K1 angeschlossen ist, und über eine Ausgangsklemme AK2, die an den Gate-Anschluß des dritten Transistors T3 angeschlossen ist. Die zweite Spitzenwerterfassungseinheit SWE2 weist eine mit einer ersten Klemme an den Knoten für Bezugspotential M angeschlossene zweite Kapazität C2 auf, die über eine zweite Diode D2 an die erste Anschlußklemme K1 angeschlossen ist, wobei die Anode der zweiten Diode D2 an die zweite Kapazität C2 und die Kathode an die erste Anschlussklemme K1 angeschlossen ist. Ein der zweiten Kapazität C2 und der zweiten Diode D2 gemeinsamer Knoten 20 ist an eine Ausgangsklemme AK2 und damit an den Gate-Anschluß des dritten Transistors T3 angeschlossen. Zudem ist zwischen diesen Knoten 20 und den Knoten für Versorgungspotential Vdd ein zweiter Widerstand R2 geschaltet.

Im eingeschwungenen Zustand sind an den Kapazitäten C3, C4 der Oszillatorschaltung Schwingungssignale S1, S2 abgreifbar, die sich durch eine 180°-Phasenverschiebung unterscheiden und die sich dadurch ergeben, daß die Kapazitäten C3, C4 über den Resonator RES, hier den Quarz Q, periodisch ge- und entladen werden. Die Frequenz der Schwingung ist von den Parametern der Resonatorschaltung Q abhängig.

Aufgabe der Entdämpferschaltung ist es dabei, dem Resonator RES im eingeschwungenen Zustand pro Periode die Energie zuzufügen, die an dem Widerstand R_{Q} als Schwingungsenergie verloren geht. Beim Einschalten ist es Aufgabe der Entdämpferschaltung ENT den Resonator RES soweit zu entdämpfen, daß überhaupt eine Schwingung zustande kommt und daß die Amplitude der Schwingung ansteigt.

An der ersten Anschlußklemme K1 der Oszillatorschaltung steht ein Ausgangsstrom I_{OUT} zur Verfügung, der dem Resonator RES zugeführt wird. Dieser Strom ist abhängig vom Momentanwert des an der Kapazität C3 anliegenden Schwingungssignals S2, welches zur Ansteuerung des ersten und vierten Transistors T1, T4 verwendet wird. Vernachlässigt man zunächst den zweiten und dritten Transistors T2, T3 und die Spitzenwerterfassungseinheiten SWE1, SWE2 verhält sich die Schaltung wie eine herkömmlicher CMOS-Inverter, der zur Ansteuerung von Resonatoren RES verwendet wird. Je kleiner der Momentanwert der Spannung S2 um so größer ist der Betrag der Gate-Source-Spannung des ersten Transistors T1 und um so mehr leitet dieser Transistor, um so kleiner ist aber die Gate-Source-Spannung des vierten Transistors T4 und um so mehr sperrt dieser Transistor. Steigt der Momentanwert der Spannung S2, beginnt der vierte Transistor T4 mehr zu leiten und der erste Transistor T1 mehr zu sperren. Der Ausgangsstrom I_{OUT} nimmt damit mit steigendem Momentanwert der Spannung S2 ab. Der hochohmige, zwischen die erste und zweite Anschlußklemme K1, K2 geschaltete Widerstand R3 dient zur Einstellung der Transistorarbeitspunkte auf etwa die halbe Versorgungsspannung 0.5Vdd.

Neben dem Momentanwert der Spannung S2 hängt der Ausgangsstrom U_{OUT} bei der erfindungsgemäßen Schaltung von der Amplitude der Schwingung, insbesondere der Spannung an den Kapazitäten C1, C2 ab, wie im folgenden erläutert wird.

Bei Anlegen einer Versorgungsspannung laden sich die erste und zweite Kapazität C1, C2 der Spitzenwerterfassungseinheiten SWE1, SWE2 plus bzw. minus einer Diodenspannung zunächst auf etwa die halbe Versorgungsspannung minus einer Dioden-Spannung auf, das Potential an den Gate-Anschlüssen des zweiten und dritten Transistors T2, T3 entspricht damit 0.5Vdd. Steigt das Potential an der ersten Anschlußklemme K1 über diesen Wert, fließt ein Strom über die Diode D1 auf die Kapazität C1 und das Potential an der Ausgangsklemme AK1 und damit an dem Gate-Anschluß des zweiten Transistors T2 steigt. Damit sinkt der Betrag der Gate-Source-Spannung des zweiten Transistors T2 und dieser Transistor beginnt abzuregeln. Er regelt dabei um so mehr ab, je größer das Potential an seinem Gate-Anschluß bzw. je größer die Amplitude der Schwingung S1 an der ersten Anschlußklemme K1 ist. Die erste Spitzenwerterfassungseinheit SWE erfaßt damit die Maximalwerte der Schwingung S1.

Bei kleinen Momentanwerten der Spannung S1 wird die Kapazität C2 der zweiten Spitzenwerterfassungseinheit SWE2 über die Diode D2 entladen. Damit sinkt das Potential an der Ausgangsklemme AK2 und am Gate-Anschluß des dritten Transistors T3. Der dritte Transistor T3 beginnt damit abzuregeln. Er regelt um so mehr ab, je kleiner das Potential an seinem Gate-Anschluß bzw. je kleiner der Minimalwert der Spannung S1 innerhalb einer Periode wird. Die zweite Spitzenwerterfassungseinheit erfaßt somit Minimalwerte der Schwingung S1.

Zusammenfassend gilt, je größer die Amplitude der Schwingung S1 ist, je stärker also die Auslenkungen dieser Schwingung nach oben und unten um den Mittelwert 0.5Vdd sind, um so höher wird über die erste Spitzenwerterfassungseinheit SWE1 die Gate-Ansteuerungsspannung für den zweiten Transistor T2 und um so niedriger wird über die zweite Spitzenwerterfassungseinheit SWE2 die Gate-Ansteuerungsspannung für den dritten Transistor. T3. Im Gegensatz zu den im gesättigten Betrieb arbeitenden Transitoren T2, T3 befinden sich die Transistoren T1, T4 in einem stark nichtgesättigten Betriebszustand, der beispielsweise dadurch erreicht wird, dass die wirksame Kanalweite der Kaskodetransistoren T2, T3 im Vergleich zu den Transistoren T1, T4 größer ist, beispielsweise um den Faktor 3. Bei nichtgesättigten MOS-Transistoren ist bekanntlich der Drain-Source-Strom und damit die Steilheit nicht nur von der Gate-Source-Ansteuerspannung, sondern auch noch von der jeweiligen Drain-Source-Spannung abhängig. Dies wird bei den Ausführungsbeispielen zur Steilheitssteuerung des Ausgangsstromes I_{OUT} ausgenutzt, indem mittels der von der Schwingungsamplitude abhängigen (stationären) Source-Spannung der beiden inneren Transistoren T2, T3 die Steilheit der beiden äußeren Transistoren T1, T4 gesteuert wird. Bei kleinen Schwingungsamplituden ist deren Drain-Source-Spannung relativ groß und damit sind auch deren Steilheit und zugehöriger Ausgansstrom I_{OUT} relativ groß. Je größer die Schwingungsamplitude wird, desto mehr werden über die kleiner werdenden Drain-Source-Spannungen der Transitoren T1, T4 deren Steiheiten abgeregelt, wodurch auch der Ausgangstrom I_{OUT} abnimmt.

Der Ausgangsstorm I_{OUT} ist bei der erfindungsgemäßen Schaltung neben dem Momentanwert der Spannung S2 somit auch von der Amplitude der Schwingung abhängig. Die Transistoren T1, T4 sind dabei so dimensioniert, daß bei kleinen Amplituden, insbesondere nach dem Einschalten, ein vergleichsweise großer Strom I_{OUT} an die erste Anschlußklemme K1 fließt, um auch bei großen Widerständen R_{Q} und damit großer Dämpfung des Resonators RES eine Schwingung zu erreichen. Die Transistoren T1, T2, T3, T4 sind dazu entsprechend groß dimensioniert und verfügen so über eine entsprechend große Steilheit. Mit zunehmender Amplitude der Schwingung und zunehmender Abregelung des zweiten und dritten Transistors T2, T3 reduziert sich die Steilheit der Gesamtanordnung. Die Amplitude der Schwingung S1 regelt sich auf den größten Wert ein, der im gesättigten Betrieb der Transistoren T2, T3 erreichbar ist, wodurch bei geringer Stromaufnahme eine große Amplitude möglich ist. Die Stromaufnahme der erfindungsgemäßen Schaltung ist bei Verwendung von guten Quarzen mit geringer Dämpfung nicht höher, sondern eher geringer, als die herkömmlicher Oszillatorschaltungen.

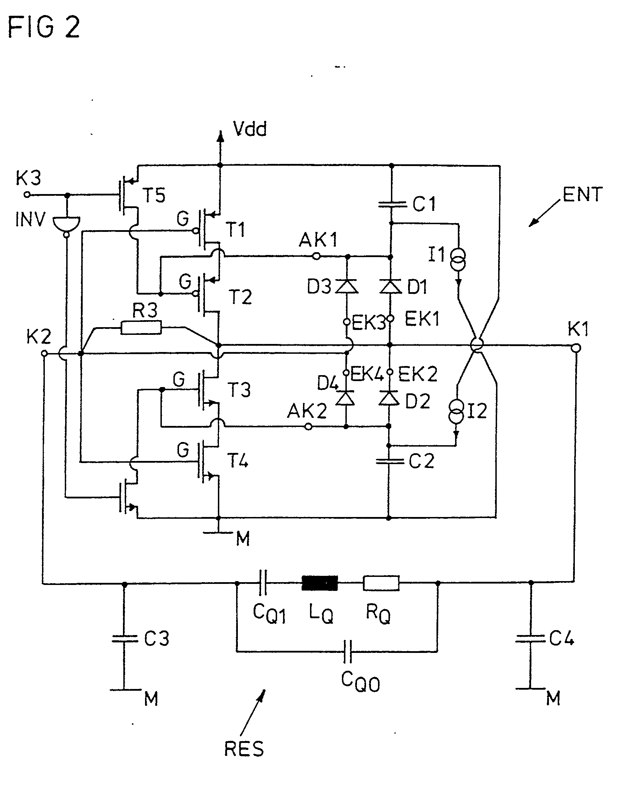

Fig. 2 zeigt eine weitere Ausführungsform der erfindungsgemäßen Oszillatorschaltung, die sich von der in Fig. 1 gezeigten dadurch unterscheidet, daß die Widerstände der Spitzenwerterfassungseinheiten als Stromquellen I1, I2 ausgebildet sind.

Die erste Kapazität wird durch die erste Stromquelle I1 dauernd entladen, die zweite Kapazität durch die zweite Stromquelle I2 dauernd geladen. Die Stromquellen sind allerdings so dimensioniert, daß diese Ladung bzw. Entladung langsam gegenüber dem Laden bzw. Entladen der Kapazitäten C1, C2 über die Dioden D1, D2 erfolgt, um den Effekt der Spitzenwerterfasung nicht zunichte zu machen.

Die in Fig. 2 dargestellte erste Spitzenwerterfassungseinheit SWE1 weist eine dritte Diode D3 auf, die zwischen die zweite Anschlußklemme K2 und die erste Kapazität C1 geschaltet ist. Die erste Spitzenwerterfassungseinheit SWE1 erfaßt damit neben dem Maximalwert der Schwingung S1 auch den Maximalwert der Schwingung S2, wobei das an der Ausgangsklemme AK1 anliegende Signal jeweils vom größeren dieser beiden Werte abhängig ist. Dementsprechend weist die zweite Spitzenwerterfassungseinheit SWE2 eine vierte Diode D4 auf, die zwischen die zweite Anschlußklemme K2 und die Kapazität C2 geschaltet ist. Somit erfaßt die zweite Spitzenwerterfassungseinheit SWE2 neben dem Minimalwert der Schwingung S1 auch den Minimalwert der Schwingung S2.

Die in Fig. 2 dargestellte Schaltung weist des weiteren einen fünften und sechsten Transistor T5, T6 auf, wobei die Laststrecke des fünften Transistors T5 zwischen den Knoten für Versorgungspotential Vdd und den Gate-Anschluß des zweiten Transistors T2 und die Laststrecke des sechsten Transistors T6 zwischen den Knoten für Bezugspotential M und den Gate-Anschluß des dritten Transistors T3 geschaltet ist. Der Gate-Anschluß des fünften Transistors T5 ist an eine dritte Anschlußklemme K3, der Gate-Anschluß des sechsten Transistors T6 über einen Invertierer INV an die dritte Anschlußklemme K3 angeschlossen. Die fünften und sechsten Transistoren T5, T6 dienen als Schalter für die Ansteuerschaltung.

Liegt an der dritten Anschlußklemme K3 ein High-Pegel an, sperrt der fünfte Transistor T5. An dem Gate des sechsten Transistors T6 liegt dann ein Low-Pegel an, weshalb dieser Transistor ebenfalls sperrt. Die Schaltung verhält sich wie oben beschrieben. Wird an die dritte Anschlußklemme K3 ein Low-Pegel angelegt, leitet der fünfte Transistor T5, der somit das Gate des zweiten Transistors T2 annäherungsweise auf Versorgungspotential Vdd hochzieht, weshalb dieser sperrt. Am Ausgang des Invertierers INV und damit am Gate des sechsten Transistors T6 liegt ein High-Pegel an, wenn an der dritten Anschlußklemme K3 ein Low-Pegel anliegt. Damit leitet der sechste Transistor T6 und entlädt das Gate des dritten Transistors T3 der somit sperrt. Die Oszillatorschaltung kann so durch Anlegen eines entsprechenden Pegels an die dritte Anschlußklemme in einen betriebsbereiten (die Transistoren T2, T3 leiten) bzw. in einen nicht betriebsbereiten (die Transistoren T2, T3 sperren) Zustand versetzt werden.

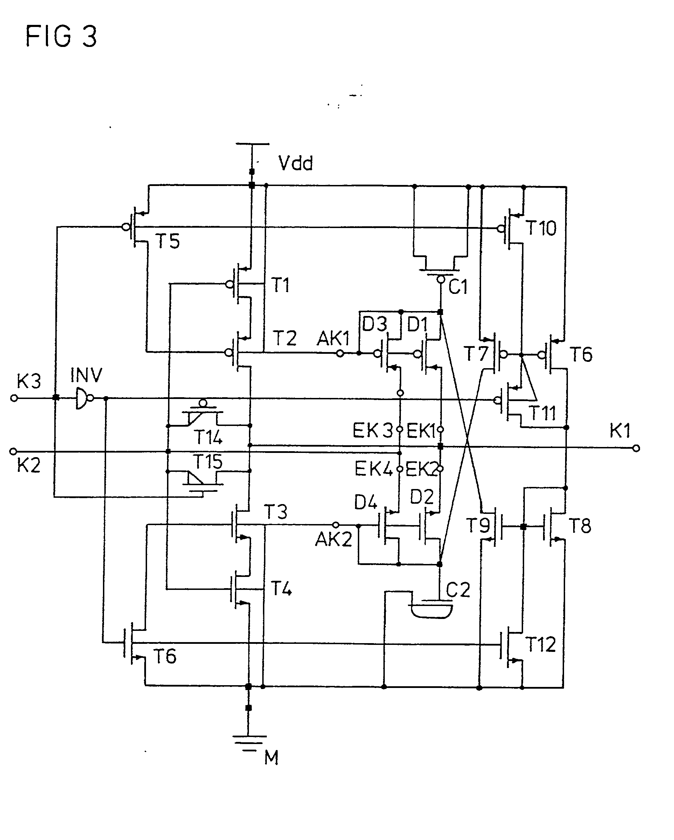

Fig. 3 zeigt eine weitere Ausführungsform der erfindungsgemäßen Oszillarorschaltung. Eine Stromquelle der ersten Spitzenwerterfassungseinheit SWE1 weist Transistoren T8, T9 als Stromspiegeltransistoren auf, deren Gate-Anschlüsse miteinander verbunden sind und deren Source-Anschlüsse an den Knoten für Bezugspotential M angeschlossen sind. Der Drain-Anschluß des Transistors T8 ist an seinen Gate-Anschluß angeschlossen. Der Drain-Anschluß des Transistors T9 ist an die Kapazität der ersten Spitzenwerterfassungseinheit SWE1 angeschlossen. Ein Transistor T12 ist mit seiner Laststrecke zwischen die Gate-Anschlüsse der Transistoren T8, T9 und den Knoten für Bezugspotential M geschaltet und dient zur Entladung der Gates der Transistoren T8, T9 im Falle eines Low-Pegels an der dritten Anschlußklemme, um die Stromquelle abzuschalten.

Eine Stromquelle der zweiten Spitzenwerterfassungseinheit weist Transistoren T6 und T7 als Stromspiegeltransistoren auf, deren Gate-Anschlüsse miteinander verbunden sind und deren Source-Anschlüsse an den Knoten für Versorgungspotential angeschlossen sind. Der Gate-Anschluß des Transistors T6 ist über einen Transistor T11 an seinen Drain-Anschluß angeschlossen. Der Drain-Anschluß des Transistors T7 ist an die Kapazität der zweiten Spitzenwerterfassungseinheit SWE2 angeschlossen. Ein Transistor T10 ist mit seiner Laststrecke zwischen die Gate-Anschlüsse der Transistoren T6, T7 und den Knoten für Versorgungspotential Vdd geschaltet. Die Transistoren T10, T11 sind über die dritte Anschlußklemme K3 ansteuerbar und dienen zum An- bzw. Abschalten der Stromquelle. Im Falle eines High-Pegels an der dritten Anschlußklemme K3 sperrt der Transistor T10, der Transistor T11 leitet, es fließt ein Strom über die Laststrecke des Transistors T7 auf die Kapazität C2. Im Falle eines Low-Pegels an der dritten Anschlußklemme K3 leitet der Transistor T10 und zieht die Gate-Anschlüsse der Transistoren T6, T7 auf Vdd, die somit sperren. Weiterhin sperrt der Transistor T11, die Stromquelle ist somit abgeschaltet.

Die Dioden D1, D2, D3, D4 sind bei dem in Fig. 3 dargestellten Ausführungsbeispiel als Transistoren ausgebildet, die durch Verbinden der Gate- und Drain-Anschlüsse jeweils als Dioden verschaltet sind. Außerdem ist die Kapazität C1 als FeldeffektTransistor ausgebildet, wobei als wirksame Kapazität die Gate-Kapazität der Transistoren zum Tragen kommt. Die Kapazität C2 ist als Dünnoxidkondensatorstruktur ausgebildet.

Zur Einstellung des Arbeitspunktes des ersten und vierten Transistors T1, T4 sind in Fig. 3 zwei Transistoren T14, T15 zwischen die erste und zweite Anschlußklemme geschaltet, die über die dritte Anschlußklemme K3 angesteuert werden. Die Transistoren sind dabei so dimensioniert, daß sie in leitendem Zustand einen sehr großen Laststreckenwiderstand aufweisen, so daß nur ein sehr geringer Strom zwischen den Anschlußklemmen K1, K2 fließen kann.

Bei dem in den Fig. 3 dargestellten Ausführungsbeispiel sind die Transistoren T1, T2, T5, T6, T7, T10, T11, T14, die Dioden D1, D3 und die Kapazität C1 als p-Kanal-FET ausgebildet. Die Transistoren T3, T4, T6, T8, T9, T12, die Dioden D2 und D4 sind als n-Kanal-FET ausgebildet.

### Bezugszeichenliste

- C1-C4: Kapazitäten
- C_{Q0}, C_{Q1}: Kapazitäten
- D1-D4: Dioden
- EK1-EK4: Eingangsklemmen
- ENT: Entdämpfereinrichtung
- I1, I2: Stromquellen
- INV: Invertierer
- K1-K3: Anschlußklemmen
- L_{Q}: Induktivität
- M: Bezugspotential
- R1-R3, R_{Q}: Widerstände
- SWE1, SWE2: Spitzenwerterfassungseinheiten
- T1-T12: Transistoren
- Vdd: Versorgungspotential
- RES: Resonator
- OSZ: Oszillatorschaltung

## Patentansprüche

1. Oszillatorschaltung mit folgenden Merkmalen:
- einen Resonator (RES);
- eine Entdämpfungseinrichtung (ENT) zur Amplitudenregelung der Schwingungsamplitude des Resonator (RES) mit einer ersten Anschlussklemme(K1) und einer zweiten Anschlussklemme (K2) zum Anschließen des Resonators (RES);
- die Entdämpfereinrichtung (ENT) weist weiter auf:
- einen ersten und zweiten Transistor (T1, T2), die in Reihe zwischen einen Knoten für Versorgungspotential (Vdd) und die erste Anschlussklemme (K1) geschaltet sind;
- einen dritten und vierten Transistor (T3, T4), die in Reihe zwischen die erste Anschlussklemme (K1) und einen Knoten für Bezugspotential (M) geschaltet sind;
- Steueranschlüsse des ersten und vierten Transistors sind an die zweite Anschlussklemme (K2) angeschlossen;
- die Verstärkung und/oder Steilheit ist einstellbar;
- die Werte der Verstärkung und/oder Steilheit sind in Abhängigkeit der Schwingungsamplitude regelbar; und
- die geregelten Werte der Verstärkung und/oder Steilheit sind während der ganzen Schwingungsamplitude im wesentlichen unabhängig von der Momentanspannung und/oder dem Momentanstrom an den Anschlussklemmen (K1, K2) der Entdämpfereinrichtung (ENT) und bleiben damit konstant,
**dadurch gekennzeichnet, dass**
- wenigstens eine erste Spitzenwerterfassungseinheit(SWE1) mit einer Eingangsklemme (EK1), die an die erste und/oder zweite Anschlussklemme (K1,K2) gekoppelt ist, und mit einer Ausgangsklemme (AK1), die an den Steueranschluss des zweiten Transistors (T2) oder dritten Transistors (T3) angeschlossen ist, vorgesehen ist.

2. Oszillatorschaltung nach Anspruch 1
**gekennzeichnet, durch**
- eine erste Spitzenwerterfassungseinheit (SWE1) mit einer Eingangsklemme (EK1), die an die erste Anschlussklemme (K1) angeschlossen ist, und mit einer Ausgangsklemme (AK1), die an den Steueranschluss des zweiten Transistors (T2) angeschlossen ist;
- eine zweite Spitzenwerterfassungseinheit (SWE2) mit einer Eingangsklemme (EK2), die an die erste Anschlussklemme (K1) angeschlossen ist, und mit einer Ausgangsklemme (AK2), die an den Steueranschluss des dritten Transistors (T3) angeschlossen ist;

3. Oszillatorschaltung nach Anspruch 1 oder 2,
**dadurch gekennzeichnet, daß**
die erste Spitzenwerterfassungseinheit (SWE1) eine an den Knoten für Versorgungspotential (Vdd) angeschlossene erste Kapazität (C1) aufweist, die über eine erste Diode (D1) an die erste Anschlussklemme (K1) angeschlossen ist, und dass ein der ersten Kapazität (C1) und der erste Diode (D1) gemeinsamer Knoten an die Ausgangsklemme (AK1) und über einen ersten Widerstand (R1, I1) an den Knoten für Bezugspotential (M) angeschlossen ist.

4. Oszillatorschaltung nach einem der vorangehenden Ansprüche,
**dadurch gekennzeichnet, dass**
die zweite Spitzenwerterfassungseinheit (SWE2) eine an den Knoten für Bezugspotential (M) angeschlossene zweite Kapazität (C2) aufweist, die über eine zweite Diode (D2) an die erste Anschlussklemme (K1) angeschlossen ist, und dass ein der zweiten Kapazität (C2) und der zweiten Diode (D2) gemeinsamer Knoten an die Ausgangsklemme (AK2) und über einen zweiten Widerstand (R2, I2) an den Knoten für Versorgungspotential (Vdd) angeschlossen ist.

5. Oszillatorschaltung nach einem der vorangehenden Ansprüche,
**dadurch gekennzeichnet, dass**
eine dritte Diode (D3) zwischen die zweite Anschlussklemme (K2) und die erste Kapazität (C1) der ersten Spitzenwerterfassungseinheit (SWE1) geschaltet ist.

6. Oszillatorschaltung nach einem der vorangehenden Ansprüche,
**dadurch gekennzeichnet, dass**
eine vierte Diode (D4) zwischen die zweite Anschlussklemme (K2) und die erste Kapazität (C2) der zweiten Spitzenwerterfassungseinheit (SWE2) geschaltet ist.

7. Oszillatorschaltung nach einem der vorangehenden Ansprüche,
**dadurch gekennzeichnet, dass**
der erste und zweite Transistor (T1, T2) als p-Kanal-MOSFET und dass der dritte und vierte Transistor (T3, T4) als n-Kanal-MOSFET ausgebildet sind.

8. Oszillatorschaltung nach einem der vorangehenden Ansprüche,
**dadurch gekennzeichnet, dass**
die Dioden (D1, D2, D3, D4) als Transistoren ausgebildet sind, die als Dioden verschaltet sind.

9. Oszillatorschaltung nach einem der vorangehenden Ansprüche,
**dadurch gekennzeichnet, dass**
die Kapazitäten als MOS-Kapazitäten ausgebildet sind.

10. Oszillatorschaltung nach einem der vorangehenden Ansprüche,
**dadurch gekennzeichnet, dass** die Dioden (D1, D2, D3, D$) als MOS-Transistoren ausgebildet sind.

## Claims

1. Oscillator circuit with the following features:
- a resonator (RES);
- a device for amplitude regulation (ENT) of the oscillation amplitude of the resonator (RES) with a first circuit terminal (K1) and a second circuit terminal (K2) to connect the resonator (RES);
- the device for amplitude regulation (ENT) also comprises
- a first and second transistor (T1, T2), which are connected in series between a node for supply potential (Vdd) and the first circuit terminal (K1);
- a third and fourth transistor (T3, T4), which are connected in series between the first circuit terminal (K1) and a node for reference potential (M);
- control ports of the first and fourth transistor are connected to the second circuit terminal (K2);
- the amplification and/or gradient is variable;
- the values of the amplification and/or gradient can be varied dependent on the oscillation amplitude; and
- the varied values of the amplification and/or gradient are substantially independent of the momentary voltage and/or the momentary current at the circuit terminals (K1, K2) of the device for amplitude regulation (ENT) and therefore remain constant over the full oscillation period, **characterized in that**
- at least one first peak value detector (SWE1) is provided with an input terminal (EK1), which is coupled to the first and/or second circuit terminal (K1, K2), and with an output terminal (AK1), which is connected to the control port of the second transistor (T2) or third transistor (T3).

2. Oscillator circuit according to claim 1,
**characterized by**
- a first peak value detector (SWE1) with an input terminal (EK1), which is connected to the first circuit terminal (K1), and with an output terminal (AK1), which is connected to the control port of the second transistor (T2).
- a second peak value detector (SWE2) with an input terminal (EK2), which is connected to the first circuit terminal (K1), and with an output terminal (AK2), which is connected to the control port of the third transistor (T3).

3. Oscillator circuit according to claim 1 or 2, **characterized in that** the first peak value detector (SWE1) comprises a first capacitor (C1), connected to the node for supply potential (Vdd) which is connected across a first diode (D1) to the first circuit terminal (K1), and **in that** a node, common to the first capacitor (C1) and the first diode (D1), is connected to the output terminal (AK1) and across a first resistor (R1, I1) to the node for reference potential (M).

4. Oscillator circuit according to anyone of the above claims, **characterized in that** the second peak value detector (SWE2) comprises a second capacitor (C2) connected to the node for reference potential (M), which is connected across a second diode (D2) to the first circuit terminal (K1), and **in that** a node, common to the second capacitor (C2) and the second diode (D2), is connected to the output terminal (AK2) and across a second resistor (R2, 12) is connected to the node for supply potential (Vdd).

5. Oscillator circuit according to anyone of the above claims, **characterized in that** a third diode (D3) is connected between the second circuit terminal (K2) and the first capacitor (C1) of the first peak value detector (SWE1).

6. Oscillator circuit according to anyone of the above claims,
**characterized in that** a fourth diode (D4) is connected between the second circuit terminal (K2) and the first capacitor (C2) of the second peak value detector (SWE2).

7. Oscillator circuit according to anyone of the above claims,
**characterized in that** the first and second transistor (T1, T2) are designed as P channel-MOSFETs and **in that** the third and fourth transistor (T3, T4) are designed as N channel-MOSFETs.

8. Oscillator circuit according to anyone of the above claims,
**characterized in that** the diodes (D1, D2, D3, D4) are designed as transistors, which are interconnected as diodes.

9. Oscillator circuit according to anyone of the above claims,
**characterized in that t**he capacitors are designed as MOS capacitors.

10. Oscillator circuit according to anyone of the above claims,
**characterized in that** the diodes (D1, D2, D3, D4) are designed as MOS transistors.

## Revendications

1. Circuit oscillant comprenait
- un résonateur (RES),
- une installation de compensation de l'amortisseur (ENT) pour réguler l'amplitude d'oscillation du résonateur (RES) comportant une première borne de branchement (K1) et une seconde borne de branchement (K2) pour brancher le résonateur (RES),
- l'installation de compensation de l'amortisseur (ENT) comporte en outre,
* un premier et un second transistor (T1, T2) branchés en série entre un noeud du potentiel d'alimentation (Vdd) et la première borne de branchement (K1),
* un troisième et un quatrième transistor (T3, T4) branchés en série entre la première borne de branchement (K1) et un noeud du potentiel de référence (M),
* des branchements de commande pour le premier et le quatrième transistor raccordés à la seconde borne de branchement (K2),
* l'amplification et/ou la pente est réglable,
* les valeurs de l'amplification et/ou de la pente sont réglables en fonction de l'amplitude d'oscillation, et
* les valeurs régulées de l'amplification et/ou de la pente sont pratiquement indépendantes de la tension instantanée pendant toute l'amplitude de l'oscillation et/ou du courant instantané appliqué aux bornes de branchement (K1, K2) de l'installation de compensation de l'amortisseur (ENT) et elles restent ainsi constantes,
**caractérisé en ce que**
- au moins une première unité de saisie de valeur maximale (SWE1) est reliée à une borne d'entrée (EK1) couplée à la première et/ou à la seconde borne de branchement (K1, K2) et à une borne de sortie (AK1) reliée au branchement de commande du second transistor (T2) ou du troisième transistor (T3).

2. Circuit oscillant selon la revendication 1,
**caractérisé par**
- la première unité de saisie de valeur maximale (SWE1) ayant sa borne d'entrée (EK1) reliée à la première borne de branchement (K1) et sa borne de sortie (AK1) reliée au branchement de commande du second transistor (T2),
- une seconde unité de saisie de valeur maximale (SWE2) ayant sa borne d'entrée (EK2) reliée à la première borne de branchement (K1) et sa borne de sortie (AK2) reliée au branchement de commande du troisième transistor (T3).

3. Circuit oscillant selon la revendication 1 ou 2,
**caractérisé en ce que**
- la première unité de saisie de valeur maximale (SWE1) comporte une première capacité (C1) reliée au noeud du potentiel d'alimentation (Vdd), cette capacité étant reliée par l'intermédiaire d'une première diode (D1) à la première borne de branchement (K1), et
- le noeud commun à la première capacité (C1) et à la première diode (D1) est relié à la borne de sortie (AK1) et par une première résistance (R1, I1) il est relié au noeud du potentiel de référence (M).

4. Circuit oscillant selon l'une des revendications précédentes,
**caractérisé en ce que**
- la seconde unité de saisie de valeur maximale (SWE2) comporte une seconde capacité (C2) reliée au noeud du potentiel de référence (M), cette seconde capacité étant reliée par une seconde diode (D2) à la première borne de branchement (K2), et
- un noeud commun à la seconde capacité (C2) et à la seconde diode (D2) est relié à la borne de sortie (AK2) et par l'intermédiaire d'une seconde résistance (R2, 12) il est relié au noeud du potentiel d'alimentation (Vdd).

5. Circuit oscillant selon l'une des revendications précédentes,
**caractérisé en ce qu'**
une troisième diode (D3) est branchée entre la seconde borne de branchement (K2) et la première capacité (C1) de la première unité de saisie de valeur maximale (SWE1).

6. Circuit oscillant selon l'une des revendications précédentes,
**caractérisé en ce qu'**
une quatrième diode (D4) est branchée entre la seconde borne de branchement (K2) et la première capacité (C2) de la seconde unité de saisie de valeur maximale (SWE2).

7. Circuit oscillant selon l'une des revendications précédentes,
**caractérisé en ce que**
le premier et le second transistor (T1, T2) sont des composants MOSFET à canal de type p et le troisième et le quatrième transistor (T3, T4) sont des composants MOSFET à canal de type n.

8. Circuit oscillant selon l'une des revendications précédentes,
**caractérisé en ce que**
les diodes (D1, D2, D3, D4) sont des transistors branchés comme des diodes.

9. Circuit oscillant selon l'une quelconque des revendications précédentes,
**caractérisé en ce que**
les capacités sont constituées par des capacités MOS.

10. Circuit oscillant selon l'une quelconque des revendications précédentes,
**caractérisé en ce que**
les diodes (D1, D2, D3, D4) sont des transistors MOS.
